Europäisches Patentamt

European Patent Office

Office européen des brevets

(11) Publication number: **0 002 364**
B1

# EUROPEAN PATENT SPECIFICATION

(45) Date of publication of patent specification: 28.04.82

(21) Application number: 78300699.2

(22) Date of filing: 30.11.78

(51) Int. Cl.³: **H 01 L 27/10,**
H 01 L 27/06, G 11 C 11/40

(54) Integrated semiconductor device and process for producing it.

(30) Priority: 01.12.77 JP 144335/77

(43) Date of publication of application:
13.06.79 Bulletin 79/12

(45) Publication of the grant of the patent:
28.04.82 Bulletin 82/17

(84) Designated Contracting States:
DE FR GB NL

(56) References cited:
GB - A - 1 391 959
US - A - 3 570 114
IBM TECHNICAL DISCLOSURE BULLETIN, vol.
15, March 1973,
New York
S. A. ABBAS: "Fet integrated circuit having two
polysilicon layers", pages 3022—3023.

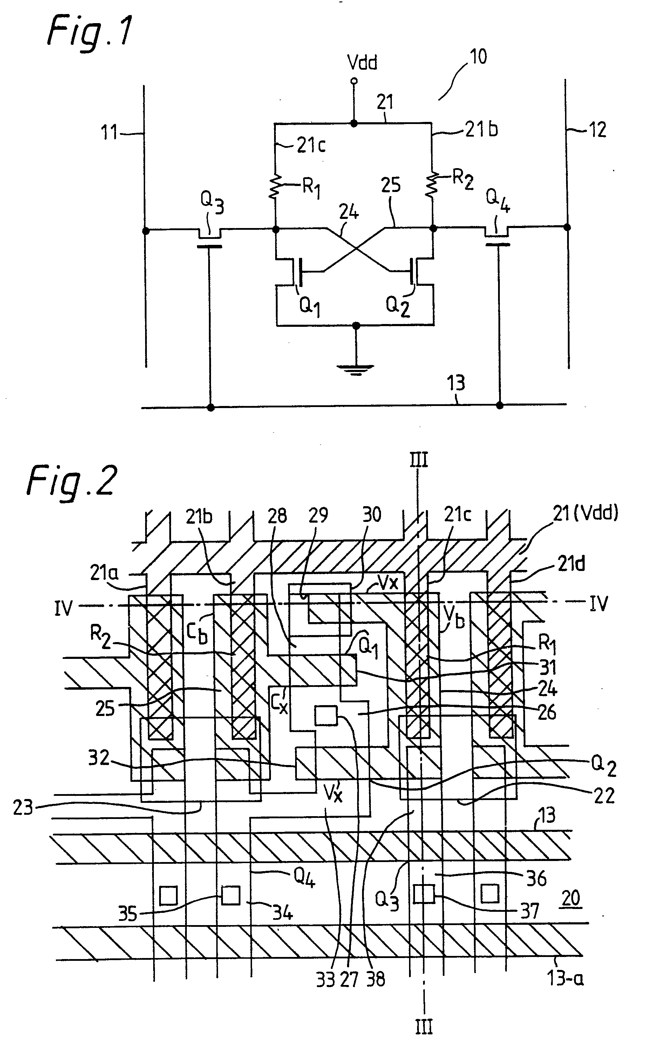

* Figures 1—4; page 3023 *

ELECTRONICS, vol. 50, May 12, 1977
New York
S. YOUNG: "Uncompromising 4-k static RAM
runs fast on little power" pages 99—103.
* Figures 1—2; page 100: "A new cell design" *

(73) Proprietor: FUJITSU LIMITED
1015, Kamikodanaka Nakahara-ku
Kawasaki-shi Kanagawa 211 (JP)

(72) Inventor: Shirai, Kazunari
32 Tsukimidai Hodogaya-ku
Yokohama-shi Kanagawa-ken (JP)
Inventor: Tanaka, Izumi
2-11 Fujizuka 2-chome Kohoku-Ku
Yokohama-shi Kanagawa (JP)

(74) Representative: Abbott, Leonard Charles et al,
GILL JENNINGS & EVERY 53/64 Chancery Lane
London WC2A 1HN (GB)

(56) References cited:
IEEE JOURNAL OF SOLID STATE CIRCUITS, vol.
SC—12, October 1977.
T. R. O'CONNELL et al.: "Two static 4k clocked
and nonclocked RAM designs", pages
497—501.

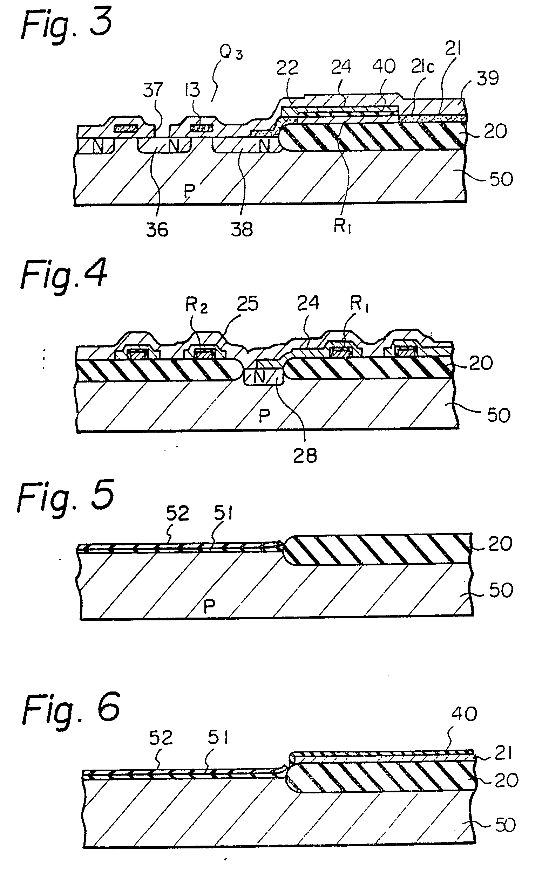

* Figures 6—7; page 500, lefthand column, lines
4—9 *

Integrated semiconductor device and process for producing it

The present invention relates to a semiconductor device according to the first part of claim 1, as well as to a process for producing that semiconductor device according to the first part of claim 7. Such a device and such a process are known from the GB—A—1 391 959.

A semiconductor device of integrated type is referred to as a semiconductor integrated circuit (I.C.), wherein all of the circuit element, i.e. such active elements as a bipolar transistor or a unipolar transistor, typically an MOS (metal oxide semiconductor) transistor, and such passive elements as a diffused resistor or capacitor, are formed on the surface of a semiconductor substrate. Since it is necessary to enhance the integration degree of the circuit elements, so as to produce the semiconductor integrated circuit at low cost, attempts have been made, in the formation of the circuit elements on the semiconductor substrate, to reduce the surface area of the circuit element as much as possible. In addition, various arrangements of the circuit elements suited for a high density integrated circuit have been devised, in accordance with the kinds of the integrated circuit, by experts in the art. Furthermore, the kinds of the circuit elements suited for the high density integrated circuit are carefully selected. For example, in a static random-access memory, in which flip flop circuits were constituted by means of MOS transistors, the all transistor type memory cell was conventionally produced by utilizing the channel resistance of the MOS transistors for a resistance load of the memory cell, so that the integration degree of the random-access memory could be enhanced. Since the conventional diffused resistor had to be rather long, the channel resistance was used instead of the diffused resistor. However, in accordance with a recent development in the semiconductor industry, polycrystalline silicon layers having a high resistance can be reliably formed by a chemical vapour growth technique, so that layers having constant resistance can be repeatedly reproduced.

An example of this technique is disclosed in British Patent Specification No. 1391959. As shown in Figures 2a—2e of this specification, a resistor 11 was formed from a layer 27 of polycrystalline silicon. This layer was covered by an insulating layer 37 allowing an aluminium wire (50, Fig. 3) to make contact with a field electrode 17. This improved the overall circuit density, but not sufficient use was made of the surface of the resistor and there was much scope for making the circuit still more compact. Furthermore the resistance of the resistor could not be determined precisely because it was influenced by the diffusion of the dopant (c.f. Figure 2c).

The present inventors conducted research directed to replacing the MOS transistor used for the load of the memory cell with a resistor element made from the polycrystalline silicon having a high resistance, and recognized during the research the following requirement. Namely, the resistor element(s) must be isolated from the other elements and the wiring connecting various circuit elements of the memory cell, without reducing the integration degree thereof, while the resistor element(s) must be easily formed and precisely adjusted to a predetermined resistance value in the production of the memory cell.

It is therefore an object of the invention as claimed in claim 1, and of the preferred forms of the invention as claimed in claims 2 to 6, to provide, for a semiconductor device having an integrated resistor element, an improved structure suited to high density integrated circuits. It is a further object of the invention as claimed in claim 7, and of the preferred forms of the invention as claimed in claims 8 to 15, to provide a process for producing such a device.

When the second polycrystalline layer is used as a conductor, for electrically connecting the resistor element or elements with other predetermined elements of the semiconductor device, it is possible to produce a semiconductor device with a high circuit density. Preferably, the terminal positions of the resistor element or elements are brought into contact with the above-mentioned conductor, via a highly conductive region.

In one form of process embodying the invention, there is produced a semiconductor device comprising a semiconductor silicon substrate and at least one insulated gate field effect transistor (IGFET) on regions of the surface of the semiconductor silicon substrate. Furthermore from the GB—A—1391 959 in addition to the first part of claim 1 a semiconductor device is known, where the conductive material layer is used for electrically connecting the said resistor element with another predetermined element of the semiconductor device, and is brought into direct contact with a part of the said first polycrystalline semiconductor material layer, and where the active element is an IGFET with the resistor element connected to its drain. The first part of claim 4 is known from the IEEE Journal of Solid-State Circuits, vol. SC-12, No. 5, Oct. 1977, p. 497—501.

In order that the invention may be better understood, some examples of semiconductor devices and processes embodying the invention will now be described with reference to the accompanying drawings, in which:—

Figure 1 is a schematic drawing of a circuit of a four transistor memory cell produced according to an embodiment of the present invention;

Figure 2 is a plane view of a random access memory manufactured from the memory cell of Figure 1;

Figure 3 is a cross sectional view of Figure 2 along the line III—III in Figure 2;

Figure 4 is a cross sectional view of Figure 2 along the line IV—IV in Figure 2;

Figure 5 is a cross sectional view of the semiconductor substrate, (hereinafter referred to as the cross sectional view) which is subjected to a selective oxidation according to an embodiment of the process of the present invention;

Figure 6 is the cross sectional view, wherein a first polycrystalline silicon layer having a high resistance is formed on the oxidation film of Figure 5, and is subjected to a surface oxidation.

Fig. 7 is the cross sectional view, wherein a gate oxide film is formed on a portion of the substrate;

Fig. 8 is the cross sectional view, wherein a photo-resist mask is formed for selectively etching a surface oxidation film and the gate oxide film;

Fig. 9 is the cross sectional view, wherein a second polycrystalline film is formed to produce a gate electrode and a second conductor wire, and;

Fig. 10 is the cross sectional view, wherein an ion implantation is carried out to form several elements of an insulated gate semiconductor FET transistor.

Referring to Fig. 1, the four transistor memory cell 10 is provided at a part of the random access memory semiconductor-device, where a pair of the bit lines 11 and 12 and one of the word lines 13 intersect with one another. The four transistor memory cell 10 includes a pair of the insulated gate FET transistors (hereinafter abbreviated as transistors) $Q_1$ and $Q_2$ for storing information, wherein the gate of each one of the transistors $Q_1$ and $Q_2$ is connected to the drain terminal of the other transistor, so that a flip-flop is formed. The resistor elements $R_1$ and $R_2$, used as a load of the transistors $Q_1$ and $Q_2$, respectively, are advantageously produced from a polycrystalline semiconductor material layer having a high resistance, i.e. the first polycrystalline semiconductor material layer according to the present invention. The elements of the four transistor memory cell 10 denoted as $Q_3$ and $Q_4$ are the transistors, wherein the gate of the transistors $Q_3$ and $Q_4$ is controlled by a voltage applied thereto through the word line 13. The transistors $Q_3$ and $Q_4$ connect the drain terminals of the transistors $Q_1$ and $Q_2$ to the bit lines 11 and 12, respectively.

The four transistor memory cell 10 is a memory device, which is modified from a conventional six transistor memory cell, and a plurality of these cells 10 are arranged on the semiconductor substrate in a matrix form. Although not shown in Fig. 1, a decoder circuit is formed on the substrate in order to allow selection of a group of the word lines 13 and a group of the bit lines 11 and 12. A presensing amplifier (not shown) is connected between the bit lines 11 and 12 of each bit line pair. When the decoder circuit selects the pair of bit lines 11 and 12 as well as the word line 13 for reading out and writing in the information, the electric potential of each drain terminal of a pair of the transistors $Q_1$ and $Q_2$ is transmitted to the bit lines 11 and 12, respectively, through the transistors $Q_3$ and $Q_4$ driven by the selecting signals on the word line 13. The electric potential difference between the lines 11 and 12, which represents the information "1" or "0", is increased by the presensing amplifier in such a manner that the detected information is maintained. The amplified difference mentioned above is read out by a sensing amplifier at the output stage of the random access memory.

Referring to Fig. 2, in which a plan pattern of circuit elements of a random access memory is shown, it will be understood that a pattern having a high density is achieved in accordance with the present invention. The parts 20 of Fig. 2, which are not-hatched, correspond to a relatively thick field oxidation film, which is formed on several regions of a semiconductor substrate. The parts 21, of Fig. 2, which are hatched upward to the right, correspond to the electric bus line Vdd (Fig. 1) of the random access memory, which line consists of the first polycrystalline silicon layer of the present invention. The bus line Vdd includes vertically extending wires 21a, 21b, 21c and 21d. An adjacent pair 21b an 21c of these wires constitutes the conductor which is, in turn, connected to the resistor elements of one memory cell 10 (Fig. 1). Namely, the doping amount of the resistor elements is adjusted, in such a manner that these resistor elements exhibit a high resistance value required for the resistor elements $R_1$ and $R_2$, respectively, and the resistor elements are covered by a thin oxide film (not shown in Fig. 2). The thickness of this oxide film can be considerably small as explained in detail hereinbelow. This oxide film exposes the tip end of the first polycrystalline layer. Such tip end is contiguous to the resistor elements $R_1$ and $R_2$ and connects each of these elements to element of the semiconductor device. The resistor elements $R_1$ and $R_2$, the tip ends mentioned above, the conducting wires 21b, 21c and the bus line Vdd, as mentioned above, are integrally formed from a polycrystalline silicon semiconductor. However, as mentioned above the doping amount of an impurity in the resistor elements $R_1$ and $R_2$ is adjusted to a lower level than in the other part of the polycrystalline silicon semiconductor. Windows 22 and 23 are formed in the first insulating film 20 and expose the tip end parts of the first polycrystalline layer. The resistor elements $R_1$ and $R_2$, extend to the windows 22 and 23, respectively, and are connected by the tip end parts of the first polycrystalline layer to the transistors $Q_1$ and $Q_2$, respectively. Such tip ends parts are hereinafter simply referred to as the tip end of the resistor element(s).

The parts 24 and 25 of Fig. 2, hatched upward to the left, correspond to a plurality of regions of the second polycrystalline silicon layer and are connected to the exposed portion of resistor elements $R_1$ and $R_2$, respectively, which are extended into the windows 22 and 23. The second region 24 of the second polycrystalline silicon layer is used as a conductor wire pattern for connecting the gate of the transistor $Q_2$ (Figs. 1 and 2) to the drain of the transistor $Q_1$ and is positioned above the underlying resistor element $R_1$. A thin oxidation film, i.e. a silicon dioxide film (not shown in Fig. 2), electrically insulates the second region 24 of the second polycrystalline silicon layer from the resistor element $R_1$, at an overlapping portion of this second region 24 and the resistor element $R_1$. It is to be noted that, because of this overlapping and insulated structure of the second region 24 of the second polycrystalline layer and the resistor element $R_1$, the surface area of the memory cell 10 is advantageously reduced. As is apparent from Fig. 2, the same overlapping and insulated structure as mentioned above is formed in the memory cell with regard to the resistor element $R_2$ and the region 25 of the second polycrystalline silicon layer.

The parts 26 through 33 of Fig. 2 indicate various parts of the memory cell 10, for producing the circuits of the transistors $Q_1$ and $Q_2$. The first and second regions of the second polycrystalline silicon layer, further on named conductor wires 24 and 25, are provided with an advantageous form for reducing the size of the memory cell 10. Namely, one of the conductor wires 24 and 25, i.e. the conductor wire 25 made from the second polycrystalline silicon layer, has an essentially symmetrical convex shape, such as a T shape. The protruding part Cx of the T shaped conductor wire 25 includes a gate electrode 31 of the transistor $Q_1$. The remaining part Cb of the T shaped conductor wire 25, i.e. the base part thereof, covers the underlying resistor element $R_2$ and electrically connects the gate electrode 31 of the transistor $Q_1$ to the drain 33 of the transistor $Q_2$. The other conductor wire 24 made from the second polycrystalline silicon layer has essentially symmetrical concave shape, such as a U shape. The base part Vb of the conductor wire 24, i.e. a body part thereof from which two remaining parts protrude, covers the underlying resistor element $R_1$. One of the protruding parts Vx of the conductor wire 24 includes a gate electrode 32 of the transistor $Q_2$, while the other protruding part includes the drain electrode of the drain 28 of the transistor $Q_1$.

The insulated gate semiconductor FET transistors $Q_1$ and $Q_2$, for example MOS transistors, have their elements arranged in the same direction as that of the resistor elements $R_1$ and $R_2$.

Since the MOS transistors $Q_1$ and $Q_2$ (Fig. 1) are commonly grounded at their source, these transistors $Q_1$ and $Q_2$ possess a single, source region 26. It is well known that such a source region can be produced by a diffusion or ion implantation method. A contact window 27 is formed through the first oxidation film 20, so as to expose a portion of the source region 26 and to bring the exposed source region into contact with a not shown ground line, which extends vertically. A wide window 30 is formed through the first oxidation film 20, so as to expose the drain 28 including an end 29 thereof. The end of conductor wire 24 is brought into contact with the exposed drain 28. The gate 31 of the transistor $Q_1$ is established below the protruding part of the T-shaped conductor wire 25. The gate 32 of the transistor $Q_2$ is established by means of the conductor wire 24 having the U shape. One of the protruding parts of the U shape is used as the gate electrode for applying an electric potential to the substrate through a gate oxide film (not shown). Since the conductor wire 24 has a concave shape, such as a U shape, and further, the conductor wire 25 has a convex form, such as a T-shape, both conductor wires 24 and 25 can be arranged in such a manner that the protruding part Cx of the conductor wire 25 enters into the concave space defined by the concave shaped-conductor wire 24. Such arrangement of the conductor wires contributes to a reduction of the memory cell area.

The semiconductor device having the circuit illustrated in Fig. 1 can be further reduced in size when the transistors $Q_3$ and $Q_4$ are arranged in the device as follows. Since one of the source and drain regions of the transistor $Q_4$ is common with the drain region of $Q_2$, a single region 33 for these common regions is formed on the surface of the semiconductor substrate. The single region 33 extends on the semiconductor substrate to the window 23, and is brought into contact with the conductor wire 25. Namely, due to the overlapping structure of the conductor wire 25 on the region 33, such contact is realized. The other one of the source and drain regions of the transistor $Q_4$ is denoted in Fig. 2 as "34". The region 34 is formed on the semiconductor substrate, is partly exposed by the window 35 and is electrically connected through the window 35 with a vertically extending, bit line 12 (not shown in Fig. 2).

One of the source and drain regions of the transistor $Q_3$ is denoted as "38" in Fig. 2 and extends on the semiconductor substrate into the window 22, which partly exposes the region 38. Due to the overlapping structure of the conductor wire 24 on the region 38, the conductor wire 24 and the region 38 are electrically connected to one another. The other of the source and drain regions of the transistor $Q_3$ is denoted in Fig. 2 as "36". The region 36 is partly exposed by the window 37 and is electrically connected to a vertically extending bit line 11 (not shown in Fig. 2).

A memory cell is contiguous with the memory cell 10 comprising the transistors $Q_1$ and $Q_2$ shown in Fig. 1, and the two memory cells are positioned symmetrically on the semiconductor substrate with respect to a line passing across the windows 35 and 37. The contiguous memory cell mentioned above and not shown Fig. 2 includes the insulated gate transistors which are the same kind as that of the transistors $Q_3$ and $Q_4$. The regions 34 and 36 of the transistors $Q_3$ and $Q_4$, respectively, are common with one of the source and drain regions of the insulated gate transistors, mentioned above.

The horizontally extending conductor wire 13 is used for the word line and the gate electrode of the transistors $Q_3$ and $Q_4$. The conductor wire 13-a is lower than the conductor wire 13 and is the word line of the contiguous memory cell mentioned above.

As will be explained in detail herein below, the conductor wires 24 and 25 made from the second polycrystalline silicion layers can be produced simultaneously with the conductor wire 13 for the word line and the gate electrode of the transistors $Q_1$ and $Q_2$. A polycrystalline silicon material, which is originally highly doped, may be used for the conductor wires 13, 24 and 25, although such polycrystalline silicon material cannot be used for the first polycrystalline silicon layer.

Referring to Figs. 3 and 4, a thick/first oxidation film 20 is formed by a well known selective oxidation method on a portion of the P or N type, silicon substrate 50. On the first oxidation film 20 the first polycrystalline silicon layer is formed by a known chemical vapor growth method. When an impurity is not doped into the first polycrystalline silicon layers during the chemical vapor growth, the entire layer exhibits a high resistance, generally a sheet resistivity of several thousands of $M\Omega/\square$. The well known ion implantation method is preferably applied to adjust the resistivity precisely. The resistor element $R_1$ is made of a portion of the first polycrystalline silicon layer covered by the second oxidation film 40. Namely, the resistance value required for the resistor element $R_1$ is provided by the length of the second oxidation film 40. When the second oxidation film 40 is partly removed, the partial removal is conducted in such a manner that the window 22 (Figs. 2 and 3) is formed, and further, the resistance value of the resistor element $R_1$ is adjusted by the remaining length thereof. The edge of the second oxidation film 40 shown in Fig. 3 defines the window 22. The chemical vapor growth of the second, polycrystalline silicon layer is conducted by doping a high concentration of an impurity into the growing polycrystalline silicon layer and, then, the so formed second polycrystalline silicon layer is selectively removed to leave patterns of the conductor wires 24 and 25, i.e. the conductor wires for the gate electrode and word line mentioned above. As seen in Fig. 3, the conductor wire 24 is brought into contact with the tip end of the resistor element $R_1$ and the silicon substrate 50.

A diffusion or ion implantation method is employed after forming the second oxidation film 40 as shown in Fig. 3, so as the provide all of the sources and drains of the transistors $Q_1$, $Q_2$, $Q_3$ and $Q_4$. In addition, the regions of the first polycrystalline silicon layer 21 used as conductor wire and the exposed tip end of the resistor element $R_1$ are provided with a high electric conductivity by the diffusion or ion implantation method. An impurity having an opposite conductivity to the conductivity of the substrate is introduced into the drain 28 of the transistor $Q_1$, the source (36 or 38) and drain (38 or 36) of the transistor $Q_3$, the bus line 21 (Vdd), the wire for connecting the bus line 21 (Vdd) to the resistor element $R_1$, the exposed tip end of the resistor element $R_1$, as well as the sources and drains of the transistors $Q_3$ and $Q_4$, not shown in Figs. 3 and 4. These elements of the memory cell are thus provided with a desired low resistance.

A surface protection layer 39, not shown in Fig. 2, may consist of a phosphosilicate glass layer which is deposited on the top surface of the silicon substrate provided with several elements of the memory cell. The surface protection layer 39 serves as an insulating means between the underlying and overlying layers. The windows 27 (Figure 2) and 37 (Figures 2 and 3) are formed through the surface protecting layer 39.

It is to be noted that the electric connection between the resistor element $R_1$ and region 38 of one of the source and drain-regions of the transistor $Q_3$ is achieved not by direct connection between the N type region 38 and the resistor element $R_1$, but indirectly through the conductor wire 24 of the second polycrystalline silicon layer.

Referring to Figs. 5 through 10, the semiconductor substrate 50 is shown in a cross sectional view in the same crossing direction as in Fig. 3.

In Fig. 5, a P type silicon substrate 50, which is already prepared and exhibits a predetermined resistivity ranging from 1 to 50 ohm cm, is subjected to a thermal oxidation, thereby forming the silicon dioxide film 51 having a thickness of from 10 to 100 nm, on the entire surface of the P type silicon substrate 50. Subsequently, the silicon nitride layer 52 is deposited on the silicon dioxide layer 51 by the chemical vapor phase reaction of monosilane with ammonia. The silicon nitride layer should have a thickness of from 30 to 200 nm. The two layers 51 and 52 are selectively removed by a photoetching method, so as to leave a part of these layers for protecting or masking the first region of the P type silicon substrate 50, i.e. the active regions thereof for forming the source and drain of the transistors, as well as intermediate regions between these active regions.

The portion of the P type silicon substrate 50 not covered by the oxidation protecting films 51 and 52, is subjected to a selective oxidation, thereby forming a relatively thick first oxide film: 20 having a thickness of from 500 to 1000 nm. The portion mentioned above is referred to in the claims as the second region of the silicon substrate.

Referring to Fig. 6, the first polycrystalline silicon layer 21 is deposited by the decomposition of monosilane and selectively left on the first oxidation film 20 by a photo etching technique. The first polycrystalline silicon layer 21, preferably has a thickness of from 100 to 500 nm. The sheet resistivity of the first polycrystalline layer 21 directly after the deposition amounts to several thousands $M\Omega/\square$. In order to reduce or adjust the sheet resistivity to a value ranging from several $K\Omega/\square$ to several $M\Omega/\square$, an ion of arsenic of phosphorus may be ion-implanted into the first polycrystalline silicon layer 21 after or before the photo-etching of the layer 21. Such ion is implanted at a trace concentration of from $10^{12}$ to $10^{13}/cm^2$ and, therefore, does not result in difficulty in etching the polycrystalline silicon layer. In this etching the first polycrystalline silicon layer is selectively removed in such a manner that the left portion, has a cross sectional shape as shown in Fig. 6 and a flat conductor wire pattern 21, 21c, $R_1$ and $R_2$ shown in Fig. 2. Subsequently, the first polycrystalline silicon layer 21 is subjected to oxidation in a furnace having an oxidizing atmosphere at a temperature of from 1000 to 1200°C. As a result, a relatively thin second silicon dioxide film 40 having a thickness of from 10 to 250 nm is formed on the first polycrystalline silicon layer 21. The second silicon dioxide film 40 is relatively thin, as mentioned above. However, since the second silicon dioxide film electrically insulates the first and second polycrystalline silicon layers 21 and 24, respectively, the thickness of this film 40 may be 10 nm or more, so that the adjustment of its thickness can easily be carried out.

After the formation of the relatively thick second oxidation film 40 of about 200 nm, the silicon nitride film 52 and the silicon dioxide film 51 are successively removed by the etching solution of the silicon nitride and silicon dioxide, respectively. During this removal, the relatively thick second silicon dioxide film 40 is partly etched to leave the thickness suitable for insulation between the overlying and underlying layers. Since the second silicon dioxide film 40 is present during the removal of the silicon nitride layer 52, the surface of the first polycrystalline silicon layer 21 is protected from damage caused by the etching solution of the silicon nitride.

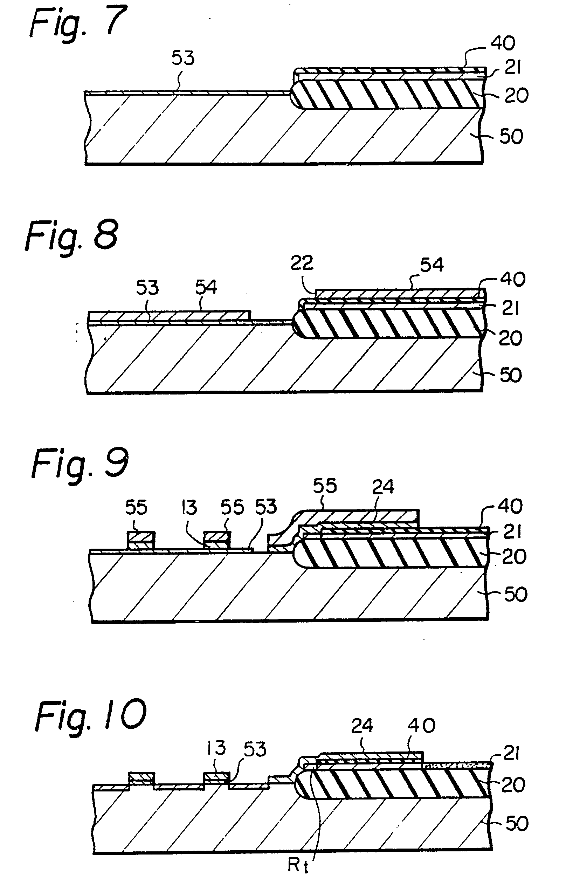

Referring to Fig. 7, a gate oxide film 53 is formed on the surface of the silicon substrate, from which the silicon dioxide film 51 and the silicon dioxide film 52 are removed. The gate oxide film 53, having a predetermined thickness, is formed by the thermal oxidation of the silicon substrate.

Referring to Fig. 8, a photoresist layer 54 is selectively formed on the top surface of the silicon substrate 50, in such a manner that the window 22 is formed by the photoresist layer 54. An exposed portion of the silicon dioxide layers 53 and 40 in the window 22 is then removed. During this removal the thick first oxidation film 20 may be partly removed to a certain thickness. Although the first oxidation film 20 becomes thinner than the original thickness of the film 20 directly after its formation, the thickness reduction is not disadvantageous to the insulating characteristic of the film 20.

Referring to Fig. 9, the second polycrystalline silicon layer 24, containing a high content of an impurity such as phosphorus, is deposited by chemical vapor growth on the entire top surface of the silicon substrate 50, from which the photoresist layer 54 is removed beforehand. The second polycrystalline silicon layer 24 is then annealed at a temperature of from 900 to 1100°C. The sheet resistivity of the annealed silicon layer 24 is decreased to a value of about 30 $M\Omega/\square$. The thickness of the second polycrystalline silicon layer 24 is preferably from 300 to 500 nm.

The photoresist layer 55 is then formed on the substrate and, thereafter selectively removed, so as to provide the layer 55 with a pattern of the word line 13, and the conductor wire patterns 24 and 25. By using the photoresist layer 55 for masking the second polycrystalline silicon layer, the exposed part of this layer is selectively removed and the masked parts of the second polycrystalline silicon layers 13, 24 (Fig. 9), and 25 (Fig. 4) are left. These layers 13, 24 and 25 are then used for masks of the gate oxide film 53 and silicon dioxide film 40, and the unmasked, exposed portion of these films 53 and 40 are removed by etching. Although during this etching the gate oxide film 53 under the film 13 is laterally etched to a length of approximately 100 nm such lateral etching, known in the semiconductor engineering as a "side etch", is not disadvantageous at all for producing a gate electrode having a width of 2 to 4 microns. After the removal of the photoresist layer 55, an ion implantation process is initiated to form the source and drain of the transistors and to increase conductivity of the various conductor wires.

Referring to Fig. 10, the second polycrystalline silicon layers 13 and 24 are used for a mask of the underlying layers during the ion implantation process. Arsenic is ion-implanted into the unmasked parts of the substrate. When the energy of ion implantation is 100 KeV, the projected range of the arsenic ion is 50 nm. Since the conductor wire 24 made from the second polycrystalline silicon layer has a thickness, for example 400 nm, larger than the projected range, the arsenic ion is not implanted at all into the first polycrystalline silicon layer 21 under the second polycrystalline silicon layer 24. The high resistance of the first polycrystalline silicon layer 21 is therefore not reduced at all by the ion implantation.

After the ion implantation, the silicon substrate 50 is annealed at a temperature of from 900 to 1100°C, thereby redistributing the arsenic ions, which are present on the exposed, top surface of the P type silicon substrate. The PN junctions for the source and drain of the transistors can therefore be produced on the exposed top surface mentioned above. Simultaneously with the formation of the PN junctions, the impurity, which was ion implanted in the bus line 21 (Vdd), the conductor wires 21a—21d, and the tip end $R_t$ of the resistor element $R_1$, is activated and reduces the resistance of these elements 21, 21a—21d and $R_t$ to a low level required.

The silicon substrate 50 processed as mentioned above is finally subjected to the formation of a surface protection layer 39 of a phosphosilicate glass layer (Figs. 3 and 4) on the entire top surface thereof. The windows 27, 34 and 37 are formed through the phosphosilicate glass layer 39, so as to connect the transistors $Q_3$ and $Q_4$ with the bit lines 11 and 12, respectively. Consequently, the semiconductor device having the cross sectional structure as shown in Figs. 3 and 4 is completed.

The process according to the present invention is illustrated with reference to Figs. 5 through 10.

While the silicon nitride layer 52 (Figs. 5 and 6) used for the selective oxidation of the first oxidation film 20 is not removed and hence remains, the surface of first polycrystalline silicon layer 21 is oxidized. If the surface of first polycrystalline silicon layer 21 is oxidized after the removal of the silicon nitride film 52, the portion of the silicon substrate 50, on which the gate is to be formed, is also oxidized during the formation of the second oxide film 40. It is, therefore, necessary to perform an additional step of removing an oxidation film formed on the exposed substrate, prior to forming a gate oxide film 53 having a predetermined thickness.

In addition, since the second oxidation film 40 (Figs. 6 and 7) is relatively thick for example 200 nm, the silicon substrate 50 can be dipped in an etching solution for the silicon nitride film 52 and the silicon dioxide film 51, without entirely removing the relatively thick second oxidation film 40. Namely, after the removal of these films 51 and 52, the partly etched second silicon dioxide film 40 still has a thickness for example 100 nm, suited for insulating between the overlying layer 24 and underlying layer 21 (Figs. 9 and 10).

Furthermore, the projected range of an ion implantation mentioned above may exceed the thickness of the second silicon dioxide film 40 (e.g. 100 nm). In the step of forming the source and drain of the transistors, and providing the conductor wires with a high conductivity, the second polycrystalline silicon layer 24 (Fig. 10) masks the underlying, resistor element $R_1$. Such masking effect is advantageous when the solid state diffusion occurs between the phosphosilicate glass of the surface protection layer 39 and the underlying layers. If the first and second polycrystalline silicon layers 21 and 24, respectively, do not overlay, a trace amount of the arsenic ion is implanted into the second silicon dioxide film 40, with the result that the phosphosilicate in the surface protection layer 39 and silicon dioxide in the second silicon dioxide film 40 form a fusible composition during the solid state diffusion mentioned above. Such fusible composition will lead to disappearance of masking function of the second oxide film 40. The overlapping structure between the resistor elements $R_1$ and $R_2$ having high resistance and the conductor wires 24 and 25 achieves not only to reduce the area of the memory cell but also to protect the second oxide film 40 from melting due to the solid diffusion.

The present invention will now be explained in further detail with reference to the following Example.

### Example

The static random access memory as shown in Figs. 1 and 2 was produced by the steps illustrated in Figs. 5 through 10. The production condition and the result were as follows.

A. Formation of Film for Preventing Oxidation (Fig. 5).

(1) Silicon substrate 50: P type conductivity with an impurity concentration of $10^{15}/cm^3$.

(2) Thermal Oxidation of the Substrate 50. The substrate was heated at 1000°C for 1 hour and the so formed silicon dioxide film 51 had a thickness of 50 nm.

(3) Deposition of the Silicon Nitride Layer. The silicon nitride layer 52 was formed by the reaction of monosilane with ammonia and 100 nm thick.

B. Formation of the first Oxidation Film (Fig. 5).

The first oxidation film 20 of 600 nm in thickness was formed by thermal oxidation at 900°C.

C. Formation of the First Polycrystalline Silicon Layer (Fig. 6).

Monosilane was decomposed at 600°C and the polycrystalline silicon was deposited as the layer 21 having a thickness 400 nm. The arsenic was ion-implanted at a concentration of $10^{12}/cm^2$.

D. Formation of the second Oxide Layer on the First Polycrystalline Silicon Layer (Fig. 6).

The second silicon dioxide layer 40, 200 nm in thickness was formed after the oxidation of the first polycrystalline silicon layer 21 at 1100°C. The silicon nitride film 52 was removed by dipping the entire substrate in a phosphoric acid solution, and then, the silicon dioxide film 51 was removed by dipping the entire substrate in a fluoric acid solution. The second silicon dioxide layer 40, had a thickness of 100 nm after the dipping mentioned above.

E. Formation of the Gate Oxidation Film (Fig. 7).

The gate oxidation film 53 was formed by thermal oxidation to a thickness of 40 nm.

F. Selective Removal of the second silicon Dioxide Films 40 and the Gate Oxide Film 53 (Fig. 8).

The films 40 and 53 were selectively etched by a fluoric acid solution.

G. Formation of the Second Polycrystalline Silicon Layers 13 and 24 (Fig. 9).

The second polycrystalline silicon layers having a dopant (impurity) of phosphorus and being deposited by a chemical vapor growth had a thickness of 400 nm. The sheet resistivity of the second polycrystalline silicon layer 24 directly after the deposition amounted to a surface resistance of 100 $\Omega/\square$ and was reduced to 30 $\Omega/\square$ by annealing at 1050°C. Photolithography was used to form a circuit pattern as shown in Fig. 9. The width of the gate electrode was 3 $\mu$.

H. Ion Implantation (Fig. 10).

Arsenic ions were ion implanted at an energy of 100 KeV and then the silicon substrate 50 so treated was annealed at 1050°C. The phosphosilicate glass layer 39 was deposited on the entire top surface of the silicon substrate 50. and was then subjected to the formation of the windows 27, 34 and 37.

## Claims

1. A semiconductor device including a semiconductor substrate (50) provided with at least one active element ($Q_1$—$Q_4$), a first insulating film (20) which covers a portion of the semiconductor substrate (50), at least one resistor ($R_1$, $R_2$) element which consists of a first polycrystalline semiconductor material layer (21) extending with regard to the length of the resistor element or elements in a predetermined direction, and which is formed on the first insulating film (20), a second insulating film (40) which covers the said resistor element or elements ($R_1$, $R_2$) and on which at least one region (24, 25) of a conductive material layer is provided, each of which has a portion extending in the said predetermined direction, characterized in that the conductive material layer is a second polycrystalline semiconductor material layer (24, 25), that the resistor element or each of the resistor elements ($R_1$, $R_2$) is completely positioned below said portion of the said region or of one of the said regions (24, 25) of the second polycrystalline semiconductor material layer, and further that in the said predetermined direction one end of the resistor element of elements ($R_1$, $R_2$) coincides with the limit of the corresponding portion of one of the said regions (24, 25) of the second polycrystalline semiconductor material layer.

2. A semiconductor device according to claim 1, characterized in that the second polycrystalline semiconductor material layer (24, 25) is used as a conductor for electrically connecting the said resistor element ($R_1$, $R_2$) with another predetermined element of the semiconductor device, and is brought into direct contact with a part of the said first polycrystalline semi-conductor material layer (21).

3. A semiconductor device according to claim 2 characterized in that the resistor element ($R_1$, $R_2$) is brought into contact with the second polycrystalline semiconductor material layer (24) via a highly conductive tip region of the first polycrystalline material layer (21), and that the resistor element, a bus line (Vdd) for electrically connecting the active element in the form of an insulated gate field effect transistor (IGFET) ($Q_1$) to a power source, and conductor wires (21b, c) for connecting the bus line (Vdd) to the or each resistor element ($R_1$, $R_2$) consist of the first polycrystalline semiconductor layer (21) integrally formed in the semiconductor device.

4. A semiconductor device according to any one of claims 1 to 3, wherein the semiconductor device comprises at least one semiconductor element with two resistor elements and, as active elements, at least one pair of IGFETs ($Q_1$, $Q_2$) each of the IGFETs ($Q_1$, $Q_2$) of the said pair having its drain connected to a different one of the resistor elements ($R_1$, $R_2$) and wherein a gate of each of the IGFETs of the said pair is connected with a drain of the other IGFETs of the said pair, characterized in that for each IGFET the gate, the electrode of the drain and a connecting member between the gate of this IGFET and the drain of the other IGFET of the said pair are formed by one of said regions (24, 25) of the second polycrystalline semiconductor layer integrally formed in the semiconductor device.

5. A semiconductor device according to claim 4, characterized in that a first region (25) of the second polycrystalline semiconductor material layers in each of the said pairs of IGFETs ($Q_1$, $Q_2$) has an essentially symmetrical convex shape of which the protruding part ($C_x$) includes a gate electrode (31) of a first ($Q_1$) of the IGFETs and of which the remaining base part (Cb) covers the underlying resistor element ($R_2$) and electrically connects the gate electrode (31) of the IGFET ($Q_1$) with the drain (33) of the second IGFET ($Q_2$); and in that a second region (24) of the second polycrystalline semiconductor material layer in each of the said pairs of IGFETs has an essentially symmetrical concave shape of which a base part (Vb) covers the underlying resistor element ($R_1$) and electrically connects the remaining two protruding parts (Vx) with one another, one of the said protruding parts including a gate electrode (32) of the said second IGFET ($Q_2$) and the other of the said protruding parts including a drain electrode (28) of the said first IGFET ($Q_1$).

6. A semiconductor device according to claim 5, characterized in that the said first region (25) and the said second region (24) of the second polycrystalline semiconductor material layers are arranged in such a manner that the said protruding part (Cx) of the said first region (25) enters into an inner space of the semiconductor device defined by the concave shape of the said second region (24).

7. A process for producing a semiconductor device comprising the steps of: forming a first insulating film (20) on a portion of the surface of a semiconductor substrate (50); forming a first polycrystalline semiconductor material layer (21) having a high resistance and extending in a predetermined direction, on the said first insulating film (20); selectively removing the said first polycrystalline semiconductor material layer (21) and thus forming at least one resistor element ($R_1$, $R_2$) and a first conductor wire (21b, 21c) pattern; selectively forming a second insulating film (40) which covers the resistor element ($R_1$, $R_2$) but which does not cover the tip (Rt, Fig. 10) of the first polycrystalline semiconductor material layer (21), the said tip being contiguous with the said resistor element; forming on the second insulating layer (40) a second conductor wire pattern of a second material layer (24) for connecting the said resistor element with a second predetermined element of the semiconductor device, the said second material layer (24) having a portion extending in the said predetermined direction and being in contact with the said tip of the first semiconductor material layer; the process characterized in that the second material layer (24) consists of polycrystalline semiconductor material and has such a length in the said predetermined direction that its limit coincides with one end of the resistor element, the process comprising the additional steps of: selectively removing exposed portions of the second insulating layer (40) using the second conductor wire pattern as a mask, thereby leaving the second insulating layer (40) under the second conductor wire pattern; and introducing an impurity into the first and second semiconductor material layers (21 and 24, respectively) having the first and second conductor wire patterns, respectively, and providing these layers with an electric conductivity.

8. A process according to claim 7, wherein an impurity is doped into the second polycrystalline semiconductor material layer (24) during the step of forming this layer.

9. A process for producing a semiconductor substrate according to claim 7 or 8, comprising the additional steps of: forming a film (51, 52) for preventing the oxidation of a first region encompassing portions of the silicon semiconductor substrate (50), on which portions an insulated gate field effect transistor (IGFET) are to be formed; forming the first insulating film (20), made of an oxide, on a remaining second region of the silicon semiconductor substrate (50); oxidizing the first polycrystalline semiconductor material layer (21), made of silicon, and thus forming the second insulating film (40) thinner than the first insulating film (20); removing the oxidation preventing film (51, 52) and subsequently forming a gate oxide film (53) having a predetermined thickness on the said first region; simultaneously with the step of forming the second polycrystalline semiconductor material layer (24) forming from the second polycrystalline semiconductor material layer (24) a gate (13) of the IGFET on at least a portion of the gate oxide film (53); and removing (a) the second insulating film (40) except under the second conductor wire pattern and (b) the portion of the gate oxide film (53) except under the gate (13).

10. A process according to claim 9, wherein the said first insulating oxide film (20) has a thickness of from 500 to 1000 nm.

11. A process according to any one of claims 7 to 10, wherein an impurity is ion-implanted into the first polycrystalline semiconductor layer (21) before or after the said step of selectively removing the first polycrystalline semiconductor layer (21).

12. A process according to any one of claims 7 to 11, wherein the first polycrystalline semiconductor layer (21) has a thickness of from 100 to 500 nm.

13. A process according to any one of claims 7 to 12, wherein the said second insulating film (40) has a thickness of from 10 to 250 nm.

14. A process according to any one of claims 7 to 13, wherein the second polycrystalline semiconductor layer (24) has a thickness of from 300 to 500 nm.

15. A process according to claim 10, wherein the step of removing the oxidation-preventing film (51, 52) is conducted by dipping the semiconductor substrate (50) in an etching solution of the said film.

**Revendications**

1. Un dispositif semi-conducteur comportant un substrat semi-conducteur (50) doté d'au moins un élément actif ($Q_1$ à $Q_4$), une première pellicule isolante (20) qui couvre une partie du substrat semi-conducteur (50), au moins un élément résistant ($R_1$, $R_2$) qui consiste en une première couche de matériau semi-conducteur polycristallin (21) s'étendant relativement à la longueur de l'élément ou des éléments résistants dans une direction prédéterminée, et qui est formé sur la première pellicule isolante (20), une deuxième pellicule isolante (40) qui couvre ledit ou lesdits éléments résistants ($R_1$, $R_2$) et sur laquelle au moins une région' (24, 25) d'une couche de matériau conducteur est disposée, chacune desquelles a une partie s'étendant dans ladite direction prédéterminée, caractérisé en ce que la couche de matériau conducteur est une deuxième couche de matériau semi-conducteur polycristallin (24, 25), en ce que l'élément résistant ou chacun des éléments résistants ($R_1$, $R_2$) est entièrement disposé sous ladite partie de ladite région ou de l'une desdites régions (24, 25) de la deuxième couche de matériau semi-conducteur polycristallin, et, en outre, en ce que, dans ladite direction prédéterminée, une extrémité de l'élément ou des éléments résistants ($R_1$, $R_2$) coïncide avec la limite de la partie correspondante d'une desdites régions (24, 25) de la deuxième couche de matériau semi-conducteur polycristallin.

2. Un dispositif semi-conducteur selon la revendication 1, caractérisé en ce que la deuxième couche de matériau semi-conducteur polycristallin (24, 25) est utilisée comme conducteur pour électriquement connecter ledit élément résistant ($R_1$, $R_2$) avec un autre élément prédéterminé du dispositif semi-conducteur, et est mise en contact direct avec une partie de ladite première couche de matériau semi-conducteur polycristallin (21).

3. Un dispositif semi-conducteur selon la revendication 2, caractérisé en ce que l'élément résistant ($R_1$, $R_2$) est mis en contact avec la deuxième couche de matériau semi-conducteur polycristallin (24) par l'intermédiaire d'une région de pointe fortement conductrice de la première couche de matériau polycristallin (21), et en ce que l'élément résistant, une ligne commune (Vdd) destinée à électriquement connecter l'élément actif sous la forme d'un transistor à effet de champ à grille isolée (IGFET) ($Q_1$) à une source électrique, et des fils conducteurs (21$b$, $c$) destinés à connecter la ligne commune (Vdd) à l'élément ou à chaque élément résistant ($R_1$, $R_2$), consistent en la première couche semi-conductrice polycristalline (21) intégralement formée dans le dispositif semi-conducteur.

4. Un dispositif semi-conducteur selon l'une quelconque des revendications 1 à 3, où le dispositif semi-conducteur comprend au moins un élément semi-conducteur ayant deux éléments résistants et, comme éléments actifs, au moins une paire de IGFET ($Q_1$, $Q_2$) chacun des IGFET ($Q_1$, $Q_2$) de ladite paire ayant son drain connecté à un élément résistant différent ($R_1$, $R_2$) et où une grille de chacun des IGFET de ladite paire est connectée avec un drain des autres IGFET de ladite paire, caractérisé en ce que, pour chaque IGFET, la grille, l'électrode du drain et un élément de connexion entre la grille de cet IGFET et le drain de l'autre IGFET de ladite paire sont formés par l'une desdites régions (24, 25) de la deuxième couche semi-conductrice polycristalline intégralement formée dans le dispositif semi-conducteur.

5. Un dispositif semi-conducteur selon la revendication 4, caractérisé en ce qu'une première région (25) des deuxièmes couches de matériau semi-conducteur polycristallin de chacune desdites paires de IGFET ($Q_1$, $Q_2$) a une forme convexe sensiblement symétrique dont la

partie saillante ($C_x$) comporte une électrode de grille (31) d'un premier ($Q_1$) des IGFET et dont la partie de base restante (Cb) couvre l'élément résistant sous-jacent ($R_2$) et connecte électriquement l'électrode de grille (31) du IGFET ($Q_1$) avec le drain (33) du deuxième IGFET ($Q_2$); et en ce qu'une deuxième région (24) de la deuxième couche de matériau semi-conducteur polycristallin de chacune desdites paires de IGFET a une forme concave sensiblement symétrique dont une partie de base (Vb) couvre l'élément résistant sous-jacent ($R_1$) et connecte électriquement les deux parties saillantes restantes (Vx) l'une avec l'autre, une desdites parties saillantes comportant une électrode de grille (32) dudit deuxième IGFET ($Q_2$) et l'autre desdites parties saillantes comportant une électrode de drain (28) dudit premier IGFET ($Q_1$).

6. Un dispositif semi-conducteur selon la revendication 5, caractérisé en ce que ladite première région (25) et ladite deuxième région (24) des deuxièmes couches de matériau semi-conducteur polycristallin sont disposées de telle manière que ladite partie saillante (Cx) de ladite première région (25) pénètre dans un espace interne du dispositif semi-conducteur défini par la forme concave de ladite deuxième région (24).

7. Un procédé de production d'un dispositif semi-conducteur comprenant les opérations consistant à: former une première pellicule isolante (20) sur une partie de la surface d'un substrat semi-conducteur (50); former une première couche de matériau semi-conducteur polycristallin (21) ayant une résistance élevée et s'étendant dans une direction prédéterminée, sur ladite première pellicule isolante (20); sélectivement enlever ladite première couche de matériau semi-conducteur polycristallin (21) et ainsi former au moins un élément résistant ($R_1$, $R_2$) et un premier schéma de câblage conducteur (21$b$, 21$c$); sélectivement former une deuxième pellicule isolante (40) qui couvre l'élément résistant ($R_1$, $R_2$) mais qui ne couvre pas la pointe (Rt, figure 10) de la première couche de matériau semi-conducteur polycristallin (21), ladite pointe étant contigüe dudit élément résistant; former sur la deuxième couche isolante (40) un deuxième schéma de câblage conducteur d'une deuxième couche de matériau (24) pour connecter ledit élément résistant avec un deuxième élément prédéterminé du dispositif conducteur, ladite deuxième couche de matériau (24) ayant une partie qui s'étend dans ladite direction prédéterminée et qui est en contact avec ladite pointe de la première couche de matériau semiconducteur; le procédé caractérise en ce que la deuxième couche de matériau (24) consiste en matériau semi-conducteur polycristallin et a, dans ladite direction prédéterminée, une longueur telle que sa limite coïncide avec une extrémité de l'élément résistant, le procédé comprenant les opérations supplémentaires consistant à: sélectivement enlever des parties exposées de la deuxième couche isolante (40) en utilisant le deuxième schéma de câblage conducteur comme masque, afin de laisser la deuxième couche isolante (40) sous le deuxième schéma de câblage conducteur; et introduire une impureté dans les première et deuxième couches de matériau semi-conducteur (21 et 24, respectivement) ayant les premier et deuxième schémas de câblage conducteurs, respectivement, et donner à ces couches une conductivité électrique.

8. Un procédé selon la revendication 7, où une impureté de dopage est introduite dans la deuxième couche de matériau semi-conducteur polycristallin (24) pendant l'opération de formation de cette couche.

9. Un procédé de production d'un substrat semi-conducteur selon la revendication 7 ou 8, comprenant les opérations supplémentaires consistant à: former une pellicule (51, 52) afin d'empêcher l'oxydation d'une première région embrassant des parties du substrat semi-conducteur de silicium (50), sur lesquelles parties un transistor à effect de champ à grille isolée (IGFET) doivent être formés; former la première pellicule isolante (20) faite d'un oxyde, sur une deuxième région restante du substrat semi-conducteur de silicium (50); oxyder la première couche de matériau semi-conducteur polycristallin (21), faite de silicium, et ainsi former la deuxième pellicule isolante (40) de manière qu'elle soit moins épaisse que la première pellicule isolante (20); enlever la pellicule (51, 52) destinée à prévenir l'oxydation et ensuite former une pellicule d'oxyde pour grille (53) ayant une épaisseur prédéterminée sur ladite première région; en même temps que l'opération consistant à former la deuxième couche de matériau semi-conducteur polycristallin (24), former à partir de la deuxième couche de matériau semi-conducteur polycristallin (24) une grille (13) du IGFET sur au moins une partie de la pellicule d'oxyde (53) pour grille; et enlever (a) la deuxième pellicule isolante (40) sauf sous le deuxième schéma de câblage conducteur et (b) la partie de la couche d'oxyde (53) pour grille sauf sous la grille (13).

10. Un Procédé selon la revendication 9, où ladite première pellicule d'oxyde isolante (20) a une épaisseur comprise entre 500 et 1000 nm.

11. Un procédé selon l'une quelconque des revendications 7 à 10, où une impureté est implantée par implantation ionique dans la première couche semi-conductrice polycristalline (21) avant ou après ladite opération consistant à sélectivement enlever la première couche semi-conductrice polycristalline (21).

12. Un procédé selon l'une quelconque des revendications 7 à 11, où la première couche semi-conductrice polycristalline (21) a une épaisseur comprise entre 100 et 500 nm.

13. Un procédé selon l'une quelconque des revendications 7 à 12, où ladite deuxième pellicule isolante (40) a une épaisseur comprise entre 10 et 250 nm.

14. Un procédé selon l'une quelconque des revendications 7 à 13, où la deuxième couche semi-conductrice polycristalline (24) a une épaisseur comprise entre 300 et 500 nm.

15. Un procédé selon la revendication 10, où l'opération consistant à enlever la pellicule (51, 52) destinée à prévenir l'oxydation est effectuée par immersion du substrat semiconducteur (50) dans une solution d'attaque de ladite pellicule.

## Patentansprüche

1. Halbleiteranordnung mit einem Halbleitersubstrat (50), das mit wenigstens einem aktiven Element (Q1 bis Q4), mit einem ersten Isolierfilm (20), der einen Teil des Halbleitersubstrats (50) bedeckt, mit wenigstens einem Widerstandselement (R1, R2), das aus einer ersten polykristallinen Halbleitermaterialschicht (21) besteht, die sich in bezug auf die Länge des Widerstandselements oder der Elemente in einer vorbestimmten Richtung erstreckt, und das auf dem ersten Isolierfilm (20) gebildet ist, und mit einem zweiten Isolierfilm (40) versehen ist, der das Widerstandselement oder die Elemente (R1, R2) bedeckt und auf dem wenigstens eine Zone (24, 25) einer Schicht aus leitendem Material vorgesehen ist, von denen jede einen Teil aufweist, der sich in der vorbestimmten Richtung erstreckt, dadurch gekennzeichnet, daß die Schicht aus leitendem Material eine zweite polykristalline Halbleitermaterialschicht (24, 25) ist, daß das Widerstandselement oder jedes der Widerstandselemente (R1, R2) vollständig unter dem Teil der Zone oder einer der Zonen (24, 25) der zweiten polykristallinen Halbleitermaterialschicht angeordnet ist und daß in der vorbestimmten Richtung ein Ende des Widerstandselements oder der Elemente (R1, R2) mit der Grenze des entsprechenden Teils einer der Zonen (24, 25) der zweiten polykristallinen Halbleitermaterialschicht zusammenfällt.

2. Halbleiteranordnung nach Anspruch 1, dadurch gekennzeichnet, daß die zweite polykristalline Halbleitermaterialschicht (24, 25) als Leiter zum elektrischen Verbinden des Widerstandselements (R1, R2) mit einem weiteren vorbestimmten Element der Halbleiteranordnung verwendet ist und in direktem Kontakt mit einem Teil der ersten polykristallinen Halbleitermaterialschicht (21) gebracht ist.

3. Halbleiteranordnung nach Anspruch 2, dadurch gekennzeichnet, daß das Widerstandselement (R1, R2) in Kontakt mit der zweiten polykristallinen Halbleitermaterialschicht (24) über eine stark leitende Spitzenzone der ersten polykristallinen Materialschicht (21) gebracht ist und daß das Widerstandselement, eine Sammelleitung (Vdd) zum elektrischen Verbinden des aktiven Elements in der Form eines Isolierschicht-Feldeffekttransistors (IGFET) (Q1) mit einer Spannungsquelle und Leiterdrähte (21b, c) zum Verbinden der Sammelleitung (Vdd) mit dem oder jedem Widerstandselement (R1, R2) aus der ersten polykristallinen Halbleiterschicht (21) bestehen, die vollständig in der Halbleiteranordnung gebildet ist.

4. Halbleiteranordnung nach einem der Ansprüche 1 bis 3, die wenigstens ein Halbleiterelement mit zwei Widerstandselementen und als aktive Elemente mit wenigstens einem Paar IGFET (Q1, Q2) enthält, wobei der Drainanschluß jedes der IGFET (Q1, Q2) des Paars mit einem unterschiedlichen der Widerstandselemente (R1, R2) verbunden ist und wobei ein Gateanschluß jedes der IGFET des Paars mit einem Drainanschluß des anderen IGFET des Paars verbunden ist, dadurch gekennzeichnet, daß für jeden IGFET der Gateanschluß, die Elektrode des Drainanschlusses und ein Verbindungsorgan zwischen dem Gateanschluß dieses IGFET und dem Drainanschluß des anderen IGFET des Paars durch eine der Zonen (24, 25) der zweiten polykristallinen Halbleiterschicht gebildet sind, die vollständig in der Halbleiteranordnung gebildet ist.

5. Halbleiteranordnung nach Anspruch 4, dadurch gekennzeichnet, daß eine erste Zone (25) der zweiten polykristallinen Halbleitermaterialschichten in jedem der Paare der IGFET (Q1, Q2) eine im wesentlichen symmetrische konvexe Form hat, deren vorspringender Teil (Cx) eine Gateelektrode (31) eines ersten (Q1) der IGFET und deren verbleibender Grundteil (Cb) das darunterliegende Widerstandselement (R2) bedeckt und elektrisch die Gateelektrode (31) des IGFET (Q1) mit dem Drainanschluß (33) des zweiten IGFET (Q2) verbindet, und daß eine zweite Zone (24) der zweiten polykristallinen Halbleitermaterialschicht in jedem der Paare der IGFET eine im wesentlichen symmetrische konkave Form hat, deren Grundteil (Vb) das darunterliegende Widerstandselement (R1) bedeckt und elektrisch die verbleibenden beiden vorspringenden Teile (Vx) miteinander verbindet, wobei einer der vorspringenden Teile eine Gateelektrode (32) des zweiten IGFET (Q2) enthält und der andere der vorspringenden Teile eine Feldelektrode (28) des ersten IGFET (Q1) enthält.

6. Halbleiteranordnung nach Anspruch 5, dadurch gekennzeichnet, daß die erste Zone (25) und die zweite Zone (24) der zweiten polykristallinen Halbleitermaterialschichten so angeordnet sind, daß der vorspringende Teil (Cx) der ersten Zone (25) in einen inneren Raum der Halbleiteranordnung eintritt, der durch die konkave Form der zweiten Zone (24) bestimmt ist.

7. Verfahren zum Herstellen einer Halbleiteranordnung mit den Schritten: Bilden eines ersten Isolierfilms (20) auf einem Teil der Fläche eines Halbleitersubstrats (50); Bilden einer ersten polykristallinen Halbleitermaterialschicht (21), die einen hohen Widerstand aufweist und sich in einer vorbestimmten Richtung erstreckt, auf dem ersten Isolierfilm (20); wahlweises Entfernen der ersten polykristallinen Halbleitermaterialschicht (21) und damit Bilden wenigstens eines Widerstandselements (R1, R2) und eines ersten Leiterdrahtmusters (21b, 21c); wahlweises Bilden eines zweiten Isolierfilms (40), der das Widerstandselement (R1, R2) bedeckt, der jedoch die Spitze (Rt, Fig. 10) der ersten polykristallinen Halbleitermaterialschicht (21) nicht bedeckt, wobei die Spitze an das Widerstandselement angrenzt; Bilden eines zweiten Leiterdrahtmusters einer zweiten Materialschicht (24) auf der zweiten Isolierschicht (40) zum Verbinden des Widerstandselements mit einem zweiten vorbestimmten Element der Halbleiteranordnung, wobei die zweite Materialschicht (24) einen Teil aufweist, der sich in der vorbestimmten Richtung erstreckt und der in Kontakt mit der Spitze der ersten Halbleitermaterialschicht ist, dadurch gekennzeichnet, daß die zweite Materialschicht (24) aus polykristallinem Halbleitermaterial besteht und eine solche Länge in der vorbestimmten Richtung aufweist, daß ihre Grenze mit einem Ende des Widerstandselements zusammenfällt, wobei das Verfahren die zusätzlichen Schritte enthält: Entfernen der freigelegten Teile der zweiten Isolierschicht (40) unter Verwendung des zweiten Leiterdrahtmusters als Maske, wodurch die zweite Isolierschicht (40) unter dem zweiten Leiterdrahtmuster zurückgelassen wird, und Einbringen von Fremdstoff in die erste und die zweite Halbleitermaterialschichten (21 oder 24) mit jeweils dem ersten und zweiten Leiterdrahtmuster, wobei diese Schichten mit einer elektrischen Leitfähigkeit versehen werden.

8. Verfahren nach Anspruch 7, dadurch gekennzeichnet, daß ein Fremdstoff in die zweite polykristalline Halbleitermaterialschicht (24) während des Schritts des Bildens dieser Schicht dotiert wird.

9. Verfahren zum Herstellen eines Halbleitersubstrats nach Anspruch 7 oder 8 mit den zusätzlichen Schritten: Bildren eines Films (51, 52) zum Verhindern der Oxidation einer ersten Zone, die Teile des Siliziumhalbleitersubstrats (50) umfaßt, auf welchen Teilen ein Isolierschicht-Feldeffekttransistor (IGFET) gebildet werden soll; Bilden des ersten Isolierfilms (20) aus einem Oxid auf der verbleibenden zweiten Zone des Siliziumhalbleitersubstrats (50); Oxidieren der ersten polykristallinen Halbleitermaterialschicht (21) aus Silizium und somit Bilden des zweiten Isolierfilms (40) dünner als der erste Isolierfilm (20); Entfernen des Oxidationsschutzfilms (51, 52) und nachfolgendes Bilden eines Gateoxidfilms (53) mit einer vorbestimmten Dicke auf der ersten Zone; gleichzeitig mit dem Schritt des Bildens der zweiten polykristallinen Halbleitermaterialschicht (24) das Bilden eines Gateanschlusses (13) des IGFET auf wenigstens einem Teil des Gateoxidfilms (53) aus der zweiten polykristallinen Halbleitermaterialschicht (24) und Entfernen (a) des zweiten Isolierfilms (40) ausgenommen unter dem zweiten Leiterdrahtmuster und (b) des Teils des Gateoxidfilms (53) ausgenommen unter dem Gateanschluß (13).

10. Verfahren nach Anspruch 9, bei dem der erste Isolieroxidfilm (20) eine Dicke von 500 bis 1000 nm aufweist.

11. Verfahren nach einem der Ansprüche 7 bis 10, bei dem ein Fremdstoff in die erste kristalline Halbleiterschicht (21) vor oder nach dem Schritt des wahlweisen Entfernens der ersten polykristallinen Halbleiterschicht (21) ionenimplantiert wird.

12. Verfahren nach einem der Ansprüche 7 bis 11, bei dem die erste polykristalline Halbleiterschicht (21) eine Dicke von 100 bis 500 nm aufweist.

13. Verfahren nach einem der Ansprüche 7 bis 12, bei dem der zweite Isolierfilm (40) eine Dicke von 10 bis 250 nm aufweist.

14. Verfahren nach einem der Ansprüche 7 bis 13, bei dem die zweite polykristalline Halbleiterschicht (24) eine Dicke von 300 bis 500 nm aufweist.

15. Verfahren nach Anspruch 10, bei dem der Schritt des Entfernens des Oxidationsschutzfilms (51, 52) durch Eintauchen des Halbleitersubstrats (50) in eine Ätzlösung des Films ausgeführt wird.

**0 002 364**

*Fig.1*

*Fig.2*

*Fig. 3*

*Fig.4*

*Fig. 5*

*Fig. 6*

2

# Fig. 7

# Fig. 8

# Fig. 9

# Fig. 10